**Europäisches Patentamt**

**European Patent Office**

**Office européen des brevets**

(19)

(11) Veröffentlichungsnummer: **0 136 450 B1**

(12) **EUROPÄISCHE PATENTSCHRIFT**

(45) Veröffentlichungstag der Patentschrift:
28.10.87

(51) Int. Cl.⁴: **C 23 C 14/34,** C 23 C 14/20, F 21 V 7/22

(21) Anmeldenummer: **84108835.4**

(22) Anmeldetag: **26.07.84**

(54) **Verfahren zum Herstellen einer Spiegelschicht, insbesondere für Scheinwerferreflektoren.**

(30) Priorität: **15.09.83 DE 3333334**

(43) Veröffentlichungstag der Anmeldung:
**10.04.85 Patentblatt 85/15**

(45) Bekanntmachung des Hinweises auf die Patenterteilung:
**28.10.87 Patentblatt 87/44**

(84) Benannte Vertragsstaaten:
**DE FR GB IT**

(56) Entgegenhaltungen:
**EP - A - 0 069 635**
**DE - A - 2 946 713**

**PATENT ABSTRACTS OF JAPAN, unexamined applications, C Field, Vol.6, Nr.235, 20. November 1982 THE PATENT OFFICE JAPANESE GOVERNMENT, page 101 C 136**

(73) Patentinhaber: **ROBERT BOSCH GMBH, Postfach 50, D-7000 Stuttgart 1 (DE)**

(72) Erfinder: **Benz, Gerhard, Dr., Brucknerstrasse 8, D-7030 Böblingen (DE)**
Erfinder: **Ladewig, Klaus, Narzissenweg 51, D-7253 Renningen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 136 450 B1

## Beschreibung

Die Erfindung geht aus von einem Verfahren zum Herstellen einer Spiegelschicht nach der Gattung des Hauptanspruchs. Die Grundkörper reflektierender Gegenstände, beispielsweise Scheinwerferreflektoren, müssen vor dem Aufbringen der Reflexionsschicht zunächst lackiert werden, um Kratzer, Rauhigkeiten und Welligkeiten in der Oberfläche zu überdecken. Hierzu sind verschiedene Lacksysteme und Lackierverfahren bekannt. Die Lackunterlage wird anschliessend im Vakuum mit Aluminium bedampft. Bei den in der Praxis verwendeten Evakuierungsdrücken von ca. $10^{-2}$ Pa weisen aufgedampfte Aluminiumschichten aufgrund von Oxideinbau grundsätzlich mehr oder weniger grosse Druckspannungen auf. Wegen dieser Druckspannungen können für Scheinwerferspiegel nur Lacksysteme verwendet werden, von denen wenigstens die oberste Lackschicht einen Glastransformationspunkt $T_G$ hat, der höher liegt als die spätere maximale Betriebstemperatur der Reflexionsfläche, um die Ausbildung einer milchigen, oft in Regenbogenfarben schillernden Oberfläche bei einer betriebsbedingten Temperaturbelastung des Spiegels zu vermeiden. Die Lacke müssen deshalb «totgebrannt» werden, wodurch sich jedoch ihre Ausglätteigenschaften verschlechtern.

Durch die DE-OS 2 946 713 ist ein Verfahren zum Herstellen einer reflektierenden Fläche für Scheinwerfer und dergleichen bekanntgeworden, nach welchem man auf ein Blech eine thermisch härtbare Kunstharzpulverschicht aufbringt, diese unter Einwirkung von thermischer Energie zu einem Überzug härtet, der anschliessend mit einer durch Aufdampfen oder chemisches Abscheiden eines Metallspiegels aus der Lösung eines Metallsalzes aufgebrachten reflektierenden Schicht überzogen wird. Dadurch sollen Reflektoren erhalten werden, bei denen die reflektierende Schicht einwandfrei auf der gehärteten Kunststoffschicht haftet und gute Reflexionswerte erbringt.

Demgegenüber haben Versuche ergeben, dass das bekannte Verfahren die Forderungen, wie sie beispielsweise an Scheinwerfer von Kraftfahrzeugen gestellt werden, nicht zu erfüllen vermag. Dies ist insbesondere dadurch bedingt, dass die Glastemperatur solcher Lacke nur in der Grössenordnung von ca. 100 °C liegt. Pulverlacke mussten deshalb bisher vor dem Aufbringen der Reflexionsschicht mit einer zusätzlichen, hoch eingebrannten Klarlackschicht ausreichender Dicke abgedeckt werden. Trotz dieser Klarlackschicht können sich bei der Erwärmung des Spiegels die Schichtspannungen in der Reflexionsschicht lösen, wodurch matte, regenbogenfarbige Spiegel entstehen. Dies geschieht bevorzugt bei extrem hohen Druckspannungen in der Aluminiumschicht infolge ungünstiger Aufdampfbedingungen oder bei einem zu weichen Lacksystem infolge ungünstiger Aushärtebedingungen.

Es sind Verfahren zur Herstellung dünner Schichten bzw. Überzüge bekannt, die durch Aufstäuben (Sputtern) eines Beschichtungsmaterials in einem evakuierbaren Rezipienten hergestellt werden. Solche Verfahren haben den Vorzug, dass es zur Ausbildung eines Überzugs gleichmässiger Dicke auch auf grossflächigen Trägern fähig ist. Das Verfahren beruht darauf, dass man den Träger bzw. Grundkörper in eine Vakuumkammer (Rezipient) einbringt, die ein aus dem Beschichtungsmaterial bestehendes Target (Kathode) enthält, dass sodann bei reduziertem Druck ein Zerstäubungsgas, beispielsweise Argon, in die Kammer eingeleitet und eine negative Spannung an das Target zur Erzeugung eines Plasmas zwischen Target und Träger angelegt wird, wodurch sich ein Überzug des Targetmaterials auf dem Träger niederschlägt.

Im Gegensatz zu Vakuum-Aufdampfverfahren ist die Niederschlagsrate, d.h. die pro Zeiteinheit niedergeschlagene Menge des Beschichtungsmaterials, bei Kathodenzerstäubungsverfahren relativ gering. Es sind daher eine Vielzahl von Lösungen bekannt geworden, mit denen die Niederschlagsrate des Beschichtungsmaterials erhöht werden soll. Dies kann beispielsweise durch Anheben des Temperaturniveaus am Target aber insbesondere durch die Verwendung geeigneter Magnetfelder an der Kathode geschehen. Durch das ringförmig geschlossene Magnetfeld werden aus der Kathode herausgelöste Sekundärelektronen eingefangen, wodurch zum einen die Aufheizung des Substrates reduziert wird. Weiter wird die Plasmadichte in unmittelbarer Kathodennähe beträchtlich erhöht, was aufgrund des verstärkten Ionenbombardements des Targets zu einer deutlichen Steigerung der Aufstäubrate führt. Für grossflächige Kathodenkonstruktionen sind im wesentlichen zwei Magnetfeldgeometrien im Einsatz, nämlich das ebene Planarmagnetron und das Zylindermagnetron.

Aus den Abhandlungen von D.W. Hoffmann J.A. Thornton «Thin Solid Films», Bd. 45, S. 387 (1977) und J.A. Thornton, J. Tabock and D.W. Hoffmann «Thin Solid Films», Bd. 64, S. 111 (1979) kann man entnehmen, dass sich mit einem Zylindermagnetron aufgestäubte Aluminiumschichten je nach Aufstäubebedingungen sowohl mit Druck- als auch mit Zugspannungen herstellen lassen. Bei den beschriebenen Untersuchungen musste jedoch der Rezipient auf einen für eine grosserienmässige Ausnützung dieses Effektes unwirtschaftlichen Druck von $5 \times 10^{-4}$ Pa evakuiert werden. Der Argon-Sputterdruck lag im Übergang von Druck- auf Zugspannungen bei ca. $2 \times 10^{-1}$ Pa, d.h. in einem idealen Arbeitsbereich.

Für das Aufbringen der Reflexionsschicht in der Fertigung ist das Planarmagnetron aufgrund seines einfacheren Aufbaus einem Zylindermagnetron vorzuziehen. Über die Verwendung dieser Anordnung zum Aufbringen einer spannungsarmen Aluminium-Reflexionsschicht auf einen Träger liegen jedoch keine Ergebnisse vor. Aus der Abhandlung von D.W. Hoffmann, J.A. Thornton in «J. Vac. Sci. Technology», Bd. 20, S. 355–358 (1982) lässt sich aus Messwerten an anderen Stoffen lediglich ein spannungsfreier Zustand

von Al-Schichten bei Argon-Sputterdrücken von $4 \times 10^{-3}$ Pa extrapolieren. Bei einem derart niedrigen Argondruck ist jedoch ein Aufstäuben selbst mit magnetfeldunterstützten Sputterkathoden nicht möglich.

Die EP-Veröffentlichung 0 069 635 beschreibt ein Verfahren zum Herstellen einer reflektierenden Metallfläche, wonach der Grundkörper zunächst mit einer thermisch aushärtbaren Kunstharz-Pulverschicht versehen wird, die einen Überzug aus Nickel, einer Nickel-Chrom-Legierung oder einer Legierung aus Nickel, Chrom und Aluminium erhält. Auf diesen Überzug wird dann die eigentliche Aluminium-Reflexionsschicht aufgestäubt. Es hat sich gezeigt, dass sich mit einer derartigen Schichtfolge der sogenannte «Regenbogeneffekt», d.h. das Aufsteigen der Aluminiumschicht, trotz der niedrigen Glastemperatur vermeiden lässt. Dies dürfte darauf zurückzuführen sein, dass der neutrale mechanische Spannungszustand oder die leichte Zugspannung der Zwischenschicht die Druckspannungen der Aluminiumschicht kompensiert. Eine nach diesem Verfahren hergestellte Reflexionsfläche ist jedoch relativ aufwendig, da insgesamt drei Verfahrensschritte, nämlich das Aufbringen des Pulverlackes auf den Grundkörper mit anschliessender Trocknung, das Aufbringen der Metall-Zwischenschicht und schliesslich das Aufbringen der Alu-Reflexionsschicht, erforderlich sind.

Vorteile der Erfindung

Es hat sich gezeigt, dass mit dem erfindungsgemässen Verfahren bei Evakuierungsdrücken zwischen $8 \times 10^{-3}$ und $3 \times 10^{-2}$ Pa und Inertgas-Sputterdrücken zwischen $6 \times 10^{-2}$ und 1 Pa bei Beschichtungsraten von ca. 5 nm/sec unter Verwendung eines Planarmagnetrons nahezu spannungsfreie oder leicht zugspannungsbehaftete Aluminiumschichten (Al 99,5%) herstellbar sind. Dies wurde durch Beschichten von nur mit einer Pulverlackschicht überzogenen Blechen erprobt. Während selbst unter guten Vakuumverhältnissen (Evakuierungsdruck $10^{-3}$ Pa) mit relativ hoher Rate aufgedampfte Aluminiumsschichten beim Aufheizen über die Glastemperatur des Pulverlackes (im Beispiel $T_G = 100\,°C$) «aufsteigen» und die beschriebenen Regenbogenerscheinungen entstehen, konnten nach dem erfindungsgemässen Verfahren hergestellte Sputterschichten aus Aluminium bis 220 °C aufgeheizt werden, ohne dass sich der Glanz der Spiegelschicht verringert hat.

Die Grösse des Inertgas-Sputterdrucks ist abhängig von dem verwendeten Gas. Als Inertgas wird aus Kostengründen bevorzugt Argon benutzt, wobei die Argon-Sputterdrücke zwischen $6 \times 10^{-2}$ und $5 \times 10^{-1}$ Pa liegen.

Die Möglichkeit, druckspannungsfreie oder leicht zugspannungsbehaftete Reflexionsschichten aus Aluminium herzustellen, erbringt eine Erhöhung der Fertigungssicherheit, da sich leichte Schwankungen in der Glastemperatur des Lackes nicht spontan in Form von Aufsteigeeffekten bei Temperaturbelastung während der Weiterverarbeitung, z.B. bei Warmklebevorgängen, auswirken. Ausserdem kann dadurch die Einbrenntemperatur und die Einbrennzeit der Lackschicht reduziert werden, so dass sich bessere Glättungseigenschaften des Lackes und damit bessere optische Eigenschaften des Reflektors ergeben. Ausserdem können Lacksysteme mit niedriger Glastemperatur, insbesondere Pulverlacke, eingesetzt werden, die mit einfachen Auftragsmethoden auf den Grundkörper aufgebracht werden können, z.B. durch elektrostatisches Aufspritzen oder durch ein bekanntes elektrochemisches Auftragsverfahren.

## Patentansprüche

1. Verfahren zum Herstellen einer Spiegelschicht, insbesondere für Scheinwerferreflektoren, wobei auf eine vorzugsweise thermisch härtbare Lackschicht, insbesondere Kunstharz-Pulverschicht, des Grundkörpers in einem evakuierbaren Rezipienten eine Schicht aus Aluminium aufgestäubt wird, dadurch gekennzeichnet, dass das Aufstäuben der Aluminiumschicht nach einem Evakuieren auf Drücke von $8 \times 10^{-3}$ bis $3 \times 10^{-2}$ Pa bei Inertgas-Sputterdrücken zwischen $6 \times 10^{-2}$ und 1 Pa bei Beschichtungsraten von ca. 5 nm/sec unter Verwendung eines Magnetrons, vorzugsweise eines Planarmagnetrons, erfolgt.

2. Verfahren nach Anspruch 1, dadurch gekennzeichnet, dass als Inertgas Argon verwendet wird, wobei der Inertgas-Sputterdruck zwischen $6 \times 10^{-2}$ und $5 \times 10^{-1}$ Pa liegt.

## Revendications

1. Procédé pour fabriquer une couche réfléchissante, notamment pour réflecteurs de projecteurs, dans lequel sur une couche de laque durcissable par voie thermique de préférence, notamment une couche de poudre de résine synthétique, du corps de base, on applique, en la répartissant à l'état de poudre dans un récipient se mettant sous vide, une couche en aluminium, procédé caractérisé en ce que l'application à l'état de poudre de la couche d'aluminium s'effectue après une mise sous vide à des pressions de $8 \times 10^{-3}$ à $3 \times 10^{-2}$ Pa, sous des pressions par crépitement de gaz inerte comprises entre $6 \times 10^{-2}$ et 1 Pa, avec des taux de revêtement d'environ 5 nm/sec, en utilisant un magnétron, de préférence un magnétron planar.

2. Procédé selon la revendication 1, caractérisé en ce que l'on utilise comme gaz inerte de l'argon, la pression de crépitement du gaz inerte se situant alors entre $6 \times 10^{-2}$ et $5 \times 10^{-1}$ Pa.

## Claims

1. Process for producing a mirror layer, especially for headlamp reflectors, in which a layer of aluminium is vapour-deposited on a preferably thermo-setting lacquer layer, especially synthetic-resin powder layer, of the substrate in a vessel which can be evacuated, characterized in that the aluminium layer is vapour-deposited, after evacuation to pressures of $8 \times 10^{-3}$ to $3 \times 10^{-2}$ Pa, at inert-gas sputtering pressures of between

$6 \times 10^{-2}$ and 1 Pa at deposition rates of about 5 nm/sec., by the use of a magnetron, preferably a planar magnetron.

2. Process according to claim 1, characterized in that argon is used as inert gas, the inert-gas sputtering pressure being between $6 \times 10^{-2}$ and $5 \times 10^{-1}$ Pa.